Europäisches Patentamt

European Patent Office

Office européen des brevets

(19)

(11) **EP 1 451 846 B1**

(12) **FASCICULE DE BREVET EUROPEEN**

(45) Date de publication et mention
de la délivrance du brevet:
**01.06.2005 Bulletin 2005/22**

(21) Numéro de dépôt: **02796900.5**

(22) Date de dépôt: **06.12.2002**

(51) Int Cl.⁷: **H01J 37/077**

(86) Numéro de dépôt international:
**PCT/FR2002/004223**

(87) Numéro de publication internationale:
**WO 2003/049139 (12.06.2003 Gazette 2003/24)**

(54) **SOURCE D'ELECTRONS**

ELEKTRONENQUELLE

ELECTRON SOURCE

(84) Etats contractants désignés:
**AT BE BG CH CY CZ DE DK EE ES FI FR GB GR
IE IT LI LU MC NL PT SE SI SK TR**

(30) Priorité: **07.12.2001 FR 0115897**

(43) Date de publication de la demande:
**01.09.2004 Bulletin 2004/36**

(73) Titulaire: **CENTRE NATIONAL DE
LA RECHERCHE SCIENTIFIQUE (CNRS)
75794 Paris Cedex 16 (FR)**

(72) Inventeurs:
• **LACOSTE, Ana
F-38950 St Martin le Vinoux (FR)**
• **PELLETIER, Jacques
F-38400 Saint Martin D'Hères (FR)**
• **ARNAL, Yves, Alban-Marie
F-38320 Poisat (FR)**

(74) Mandataire: **de Beaumont, Michel
Cabinet Michel de Beaumont
1, rue Champollion
38000 Grenoble (FR)**

(56) Documents cités:
**DE-A- 19 821 802          FR-A- 2 817 392
US-A- 3 831 052          US-A- 4 684 848**

• SUGAI H ET AL: "GENERATION OF A LARGE
ELECTRON BEAM FOR PLASMA PROCESSING"
JAPANESE JOURNAL OF APPLIED PHYSICS,
PUBLICATION OFFICE JAPANESE JOURNAL
OF APPLIED PHYSICS. TOKYO, JP, vol. 28, no.
5, PART 2, 1 mai 1989 (1989-05-01), pages
L868-L870, XP000030466 ISSN: 0021-4922
• TANAKA S ET AL: "DESIGN AND
EXPERIMENTAL RESULTS OF A NEW
ELECTRON GUN USING A MAGNETIC
MULTIPOLE PLASMA GENERATOR" REVIEW
OF SCIENTIFIC INSTRUMENTS, AMERICAN
INSTITUTE OF PHYSICS. NEW YORK, US, vol.
62, no. 3, 1 mars 1991 (1991-03-01), pages
761-771, XP000224322 ISSN: 0034-6748

Il est rappelé que: Dans un délai de neuf mois à compter de la date de publication de la mention de la délivrance du brevet européen, toute personne peut faire opposition au brevet européen délivré, auprès de l'Office européen des brevets. L'opposition doit être formée par écrit et motivée. Elle n'est réputée formée qu'après paiement de la taxe d'opposition. (Art. 99(1) Convention sur le brevet européen).

**Description**

La présente invention concerne le domaine des sources d'électrons. Plus particulièrement, la présente invention concerne la production de faisceaux étendus d'électrons destinés à être injectés dans un plasma, sous vide, ou dans toute atmosphère gazeuse réactive à pression réduite.

Lors de la fabrication de circuits dans des dispositifs semiconducteurs, certaines étapes de dépôt ou de gravure réalisées dans des gaz ionisés recourent à des sources d'électrons. En effet, il peut s'avérer, par exemple, nécessaire de polariser négativement la surface d'un substrat en la bombardant par un faisceau d'électrons. Une source d'électrons peut encore être nécessaire pour générer un plasma, pour accroître le taux d'ionisation d'un plasma ou encore pour accélérer les ions d'un plasma dans lequel est placé un substrat. Par ailleurs, on souhaite utiliser des énergies de faisceaux d'électrons différentes selon l'application considérée. Par exemple, il peut être nécessaire de disposer d'un faisceau d'électrons d'une énergie de l'ordre de 100 eV pour permettre une érosion (gravure) d'un substrat.

On dispose déjà de sources d'électrons de type ponctuel telles qu'une cathode émissive chauffée. Toutefois, de telles sources présentent l'inconvénient de fournir des faisceaux de très faible section. La surface de traitement maximale possible est donc très limitée. De plus, ces sources sont peu utilisables dans les applications considérées, les gaz (plasma) en cause risquant de réagir avec l'électrode.

La partie 5.5.2 "Electron beam characteristics of miniaturized ECR plasma cathodes" de l'ouvrage "Electron Cyclotron Resonance Ion Sources and ECR Plasmas" de R. Geller, publié par l'Institute of Physics Publishing Bristol and Philadelphia (pages 352-353) décrit des sources d'électrons dans lesquelles des électrons sont extraits d'un plasma. Toutefois, de telles sources ne peuvent constituer des sources de grande surface. En effet, pour pouvoir accroître la surface d'extraction d'électrons d'un plasma, on est amené à accroître le volume du plasma. Alors, obtenir le champ électromagnétique nécessaire pour exciter le plasma à la résonance cyclotronique impose la production d'un champ magnétique continu axial d'intensité excessivement élevée. La production d'un tel champ magnétique, destiné à confiner la trajectoire des électrons extraits autour des lignes de champ magnétique impose le recours à des installations particulièrement complexes, encombrantes et coûteuses. De plus, la présence d'un champ magnétique continu axial peut poser problème dans certaines applications. Ceci limite la surface d'extraction à quelques millimètres carrés. En outre, les sources d'électrons de ce type produisent des faisceaux d'électrons d'une intensité limitée à l'ordre de la centaine de milliampères. Par ailleurs, la densité de courant présente une variation de caractère exponentiel avec l'énergie d'extraction du faisceau. Il est donc impossible d'extraire sur une surface étendue un faisceau d'électrons d'une densité de courant qui reste sensiblement stable quand le potentiel d'extraction du faisceau est modifié. De plus, celui-ci est au plus de l'ordre de la centaine de volts.

La présente invention vise à proposer une source d'électrons qui présente au moins certaines des caractéristiques suivantes :

- utilisable pour différents domaines d'application,
- propre à fournir un faisceau dont la densité de courant d'électrons soit la plus élevée possible,
- relativement stable quand on fait varier l'énergie du faisceau,
- énergie du faisceau contrôlable dans une large plage,
- surface la plus étendue possible, par exemple de quelques centimètres à quelques dizaines de centimètres de diamètre, ou plus,
- exempte des problèmes des sources connues, et notamment ne présentant pas de champ magnétique axial au niveau ou en aval de l'extraction.

Pour atteindre ces objets, la présente invention prévoit une source fournissant un faisceau d'électrons d'énergie réglable, comprenant une chambre à plasma constituée d'une enceinte ayant une surface interne d'une première valeur et d'une grille d'extraction ayant une surface d'une seconde valeur, le potentiel de la grille étant différent de celui de l'enceinte et étant réglable, caractérisée en ce que le plasma est excité et confiné dans des structures magnétiques multipolaires ou multidipolaires, le rapport de la seconde valeur sur la première valeur étant proche de la limite supérieure suivante :

$$D = \frac{1}{\beta} \sqrt{\frac{2\pi\, m_e}{m_i}} \exp(-1/2),$$

où :

β est le taux d'électrons du plasma P,

$m_e$ la masse de l'électron, et

$m_i$ est la masse des ions chargés positivement,

d'où il résulte que la densité de courant d'électrons du faisceau extrait est sensiblement stable quand la différence de potentiel grille-enceinte varie.

Selon un mode de réalisation de la présente invention, le plasma est excité et confiné par des micro-ondes à la résonance cyclotronique électronique distribuée.

Selon un mode de réalisation de la présente invention, le rapport entre la seconde valeur et la première valeur est choisi entre D/10 et D.

Selon un mode de réalisation de la présente invention, le rapport entre la seconde valeur et la première valeur est choisi entre D/2 et D.

Selon un mode de réalisation de la présente invention, la grille est divisée en une pluralité de portions de grille élémentaires.

Selon un mode de réalisation de la présente invention, diverses portions de grille sont groupées et mises à des potentiels distincts.

Selon un mode de réalisation de la présente invention, la source est suivie d'une enceinte de post-accélération.

Selon un mode de réalisation de la présente invention, la grille est formée de tubes parallèles dans lesquels circule un fluide de refroidissement.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :

la figure 1 illustre schématiquement une chambre à plasma d'extraction de particules chargées ;
la figure 2 illustre les courants électronique et ionique au niveau d'une surface d'une chambre selon la figure 1 ; et
la figure 3 illustre schématiquement une variante de source d'électrons selon l'invention.

Selon la présente invention, on utilise comme source d'électrons une chambre à plasma utilisant des structures d'excitation et de confinement utilisant des structures magnétiques multipolaires ou multidipolaires à la résonance cyclotronique électronique distribuée telles que décrites, par exemple, dans les demandes de brevet français N°85/08836, 93/02414, 94/13499 et 99/10291.

De tels dispositifs d'excitation de plasma à basse pression permettent avantageusement d'accroître la surface d'extraction d'un faisceau d'électrons sans imposer de grands volumes de champ magnétique et d'éviter la présence de champ magnétique au niveau et en aval de l'extraction.

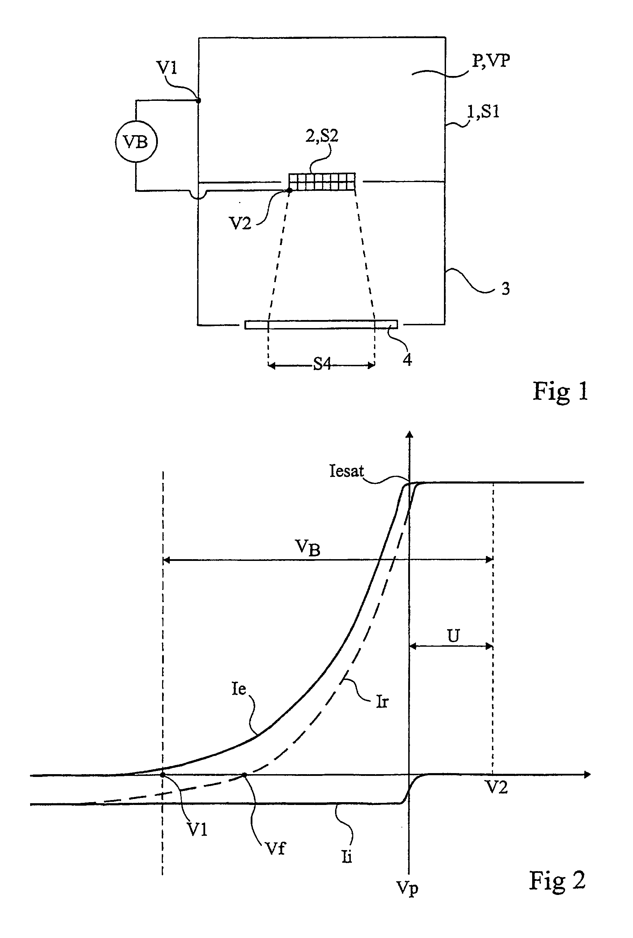

La figure 1 illustre schématiquement et partiellement un mode de réalisation particulier de l'invention. Une chambre de confinement d'un plasma P est constituée d'une enceinte 1 de surface interne $S_1$ et d'une grille d'extraction 2 de surface $S_2$. La grille 2, isolée de l'enceinte 1, est polarisée par une tension $V_B$ au potentiel $V_2$ par rapport à cette enceinte. La tension $V_B$ est réglable par un utilisateur. On souhaite extraire du plasma P des électrons. Le potentiel $V_2$ de la grille 2 doit donc être supérieur au potentiel $V_1$ de l'enceinte 1, c'est-à-dire que la tension $V_B$ est positive ($V_B = (V_2 - V_1) > 0$). Les structures d'excitation magnétique multipolaires ou multidipolaires ne sont pas représentées en figure 1. Il s'agira, par exemple, de structures similaires à celles décrites dans les demandes de brevet français susmentionnées.

Le faisceau d'électrons ainsi produit pénètre par la grille 2 dans une enceinte 3 de confinement d'une atmosphère (gaz, gaz ionisé ou plasma) de traitement d'un élément à traiter 4, tel qu'un substrat semiconducteur. Le faisceau issu de la grille 2 pénètre dans l'enceinte 3 et permet de traiter et/ou de polariser négativement une surface $S_4$ du substrat 4.

La figure 2 illustre la variation théorique des courants correspondant aux particules extraites du plasma P en fonction de la valeur de la tension d'extraction $V_B$. On considère comme positif un courant d'électrons $I_e$ et comme négatif un courant d'ions positifs $I_i$. Plus particulièrement, il est connu, par exemple de la demande de brevet français N° 9504729 au nom du CNRS, que les courants d'électrons $I_e$ et d'ions positifs $I_i$ qui peuvent être extraits du plasma P dépendent de la différence $U = V_B - V_p$, où $V_p$ est le potentiel du plasma P. Quand U est négatif et compris entre $V_f$ et zéro, le courant d'électrons $I_e$ croît selon une loi exponentielle jusqu'à une valeur maximale de saturation $I_{esat}$. Quand U est positif, c'est-à-dire quand le potentiel de polarisation $V_B$ dépasse le potentiel du plasma $V_P$, le courant d'électrons extrait demeure constant à la valeur maximale de saturation $I_{esat}$. Par contre, le courant d'ions positifs $I_i$ extrait demeure sensiblement constant tant que U est négatif. Quand U est positif, le courant d'ions $I_i$ devient nul. La figure 2 illustre également en pointillés le courant réel $I_r$, c'est-à-dire la somme algébrique des courants d'électrons $I_e$ et d'ions positifs $I_i$. On appelle potentiel flottant $V_f$, la valeur de U pour laquelle le courant d'électrons $I_e$ est égal au courant d'ions positifs $I_i$, c'est-à-dire pour laquelle le courant réel $I_r$ est nul.

A priori, pour obtenir une source telle que définie précédemment, il suffirait d'appliquer une tension $V_B$ suffisamment forte pour se trouver dans le domaine de saturation à droite de la courbe de la figure 2. En pratique, il faut tenir compte d'un ajustement les uns par rapport aux autres du potentiel $V_P$ du plasma P et des potentiels $V_1$ de l'enceinte 1 et $V_2$ de la grille 2. En effet, un tel auto-ajustement permet de garantir à tout instant la neutralité du plasma P. Pour conserver le principe de neutralité, il faut qu'à tout instant le courant d'ions positifs sur l'ensemble des surfaces d'électrodes compense exactement le courant d'électrons sur cet ensemble des surfaces.

Pour atteindre la saturation $I_{esat}$ sur la grille 2, la caractéristique de la figure 2 montre qu'il faut que l'ajustement s'effectue de telle sorte que le potentiel $V_2$ de la grille 2 soit supérieur au potentiel $V_P$. De même, pour respecter le principe de neutralité, c'est-à-dire pour que la surface $S_1$ de l'enceinte 1 puisse absorber le courant d'ions compensant ce courant de saturation $I_{esat}$, il faut que le potentiel $V_1$ de l'enceinte 1 soit inférieur au potentiel $V_f$. La surface $S_1$ reçoit alors à la fois un courant de saturation ionique et un courant électronique comme l'illustre la figure 2.

En régime permanent, le courant électronique à saturation vers la grille 2 est donné par la relation suivante :

$$I_2 = I_{esat} = -e\,\beta\,n\,S_2\sqrt{\frac{k_B T_e}{2\pi\,m_e}},$$

où :

-e est la charge de l'électron,
$\beta$ est le taux d'électrons du plasma P,
n la densité d'ions du plasma P,
$S_2$ la surface de la grille 2,
$k_B$ la constante de Boltzmann,
$T_e$ la température de l'électron dans le faisceau, et
$m_e$ la masse de l'électron.

Le courant collecté par l'enceinte 1 est la somme d'un courant de saturation d'ions positifs et d'un courant électronique et s'exprime de la façon suivante :

$$I_1 = e n S_1 \sqrt{\frac{k_B T_e}{m_i}}\exp(-1/2) - e\beta\,n S_1 \sqrt{\frac{k_B T_e}{2\pi\,m_e}}\exp\left[\frac{e(V_1 - V_P)}{k_B T_e}\right],$$

où mi est la masse des ions chargés positivement.

Alors, pour respecter la condition de neutralité du plasma il faut $I_1+I_2=0$, ce qui conduit à la relation suivante :

$$V_P - V_1 = -\frac{k_B T_e}{e}\ln\left[\frac{1}{\beta}\sqrt{\frac{2\pi\,m_e}{m_i}}\exp(-1/2) - \frac{S_2}{S_1}\right].$$

En outre, l'ajustement automatique des potentiels doit s'effectuer de telle sorte que cette différence soit positive. Il faut donc que le rapport des surfaces soit tel que :

$$\frac{S_2}{S_1} < \frac{1}{\beta}\sqrt{\frac{2\pi m_e}{m_i}}\exp(-1/2).$$

Par souci de simplification pour la suite de l'exposé, on appellera D la limite optimale ainsi définie, c'est-à-dire :

$$D = \frac{1}{\beta}\sqrt{\frac{2\pi m_e}{m_i}}\exp(-1/2) \cong \frac{1,5}{\beta}\sqrt{\frac{m_e}{m_i}}$$

Cette condition étant respectée, la surface $S_1$ prend un potentiel $V_1$ proche du potentiel flottant $V_f$, le potentiel $V_2$ de la surface $S_2$ prend une valeur positive par rapport au potentiel plasma $V_P$ et reçoit une densité de courant électronique égale à la densité de courant de saturation électronique. L'énergie des électrons du faisceau sortant de la grille 2 est alors de l'ordre de l'énergie d'extraction $eV_B$, en supposant l'énergie thermique des électrons $k_BT_e$ négligeable devant $V_B$. L'énergie du faisceau dépend donc seulement de la différence de potentiel $V_B$ appliquée par l'utilisateur entre la grille 2 et l'enceinte 1.

Si on dépasse la limite supérieure ainsi définie, la source obtenue présente une surface étendue mais la densité du courant électronique du faisceau extrait n'est plus sensiblement stable par rapport à l'énergie d'extraction et varie de façon exponentielle avec l'énergie d'extraction.

Selon la présente invention, il est par contre possible d'obtenir un faisceau d'une section étendue d'intensité sensiblement constante ($I_{esat}$) et d'énergie contrôlée et variable ($eV_B$). Plus précisément, il est possible de faire varier à la sortie de la chambre d'extraction l'énergie des électrons dans une plage allant de quelques eV à quelques centaines d'eV, au lieu d'une dizaine d'eV avec les dispositifs antérieurs. Ce résultat est obtenu sans modifier le niveau du courant électronique extrait. Celui-ci dépend de la densité du plasma et peut atteindre des densités de courant de quelques dizaines à quelques centaines de $mA/cm^2$.

Selon l'invention, le courant est sensiblement stable, c'est-à-dire que sa variation en fonction de la tension d'extraction U n'a pas de caractère exponentiel (de type $e^U$), mais est de type $U^\alpha$ avec $\alpha < 1/2$, par exemple selon une loi en $\sqrt{U}$.

Selon l'invention, il est également possible d'optimiser la surface d'extraction $S_2$. Cette surface $S_2$ est choisie de façon que le rapport $S_2/S_1$ de la surface d'extraction sur la surface interne de l'enceinte 1 de la chambre soit inférieur à la limite D mais aussi proche que possible de celle-ci.

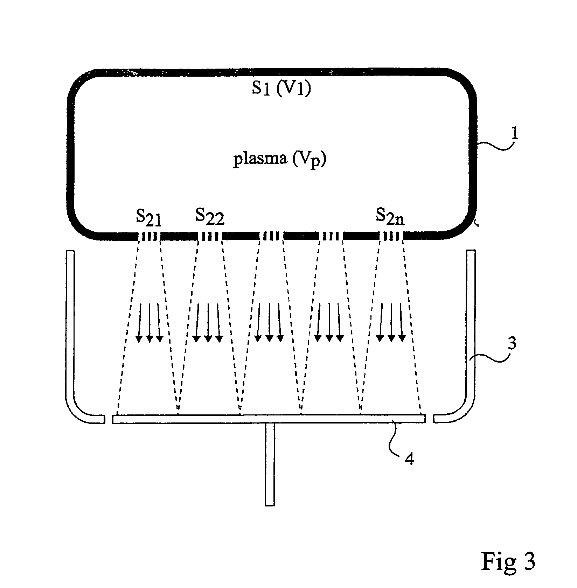

Pour augmenter la surface S4 que l'on peut traiter, on peut fractionner la grille comme cela est illustré en figure 3, la somme des surfaces $S_{21}$, $S_{22}$, .... $S_{2n}$ des portions de grille correspondant à la surface $S_2$ susmentionnée. En effet, par un effet de dispersion des faisceaux, la surface traitée est supérieure à la surface d'extraction. Les ouvertures sont formées à proximité les unes des autres de sorte que les faisceaux se dispersent en se recouvrant partiellement au niveau de l'élément 4, de telle façon que la surface $S_4$ soit bombardée de façon continue. Toutes les portions de grille peuvent être polarisées à un même potentiel $V_B$. On pourra aussi choisir de grouper les portions de grilles en ensembles polarisés à des potentiels distincts.

Un autre avantage de ce fractionnement de la surface d'extraction $S_2$ est de garantir un meilleur refroidissement de celle-ci. En effet, si on souhaite extraire un courant d'électrons d'une densité relativement importante $I_{esat}$, on observe un dégagement d'énergie thermique relativement élevé au niveau de la grille. Or, il est plus facile de refroidir une pluralité de grilles élémentaires qu'une grille d'extraction continue, notamment car la surface séparant deux grilles élémentaires peut être utilisée comme radiateur ou refroidie par circulation de fluide. Il est donc possible selon l'invention d'assurer un refroidissement efficace même pour des énergies d'extraction relativement élevées tout en garantissant une surface d'extraction étendue. Pour l'extraction à partir de plasmas de densités très élevées, il faudra prévoir un refroidissement direct de la grille, en la réalisant à l'aide d'un faisceau de tubes parallèles d'un diamètre de l'ordre du mm espacés d'une distance de l'ordre du mm.

A titre d'exemple non-limitatif, si le plasma est un plasma d'argon de numéro atomique 40, $\beta=1$ et le rapport $S_2/S_1$ doit être inférieur à $D = 1,5/(1836.40)^{1/2}$, soit 1/180. Dans un exemple pratique, on a pu confirmer le bon fonctionnement du système dans un cas particulier où la grille d'extraction avait un diamètre de 4 cm et où la chambre plasma était un cylindre de 20 cm de hauteur et de 25 cm de diamètre. On a alors $S_2 = 12,5\ cm^2$ et $S_1 = 2550\ cm^2$, le rapport $S_2/S_1$ vaut donc 1/204 ce qui remplit la condition requise. Le courant d'électrons qu'il était possible d'extraire du plasma était pratiquement de 0,5 ampère sous une tension d'extraction $V_2-V_1$ de 60 V.

Bien entendu, la présente invention est susceptible de diverses variantes et modifications qui apparaîtront à l'homme de l'art. En particulier, le plasma peut être formé à partir de gaz autres que l'argon, par exemple des gaz plus légers tels que l'hydrogène ou l'hélium.

En outre, l'homme de l'art saura compléter la source d'électrons illustrée en figure 1 avec les dispositifs appropriés nécessaires à son fonctionnement, décrits par exemple dans la demande de brevet français N° 99/10291. De même, l'enceinte de traitement 3 peut être complétée de toute façon appropriée. On pourra par exemple prévoir entre la grille d'extraction 2 de la source d'électrons et l'enceinte de traitement 3 une grille ou électrode de post-accélération.

## Revendications

1. Source fournissant un faisceau d'électrons d'énergie réglable, comprenant une chambre à plasma (P) constituée d'une enceinte (1) ayant une surface interne d'une première valeur ($S_1$) et d'une grille d'extraction (2) ayant une surface d'une seconde valeur ($S_2$), le potentiel de la grille étant différent de celui de l'enceinte et étant réglable, **caractérisée en ce que** le plasma est excité et confiné dans des structures magnétiques multipolaires ou multidipolaires, le rapport de la seconde valeur ($S_2$) sur la première valeur ($S_1$) étant proche de la limite supérieure

suivante :

$$D = \frac{1}{\beta} \sqrt{\frac{2\pi\, m_e}{m_i}} \; \exp(-1/2),$$

où :

β est le taux d'électrons du plasma P,
$m_e$ la masse de l'électron, et
$m_i$ est la masse des ions chargés positivement,

d'où il résulte que la densité de courant d'électrons du faisceau extrait est sensiblement stable quand la différence de potentiel grille-enceinte varie.

**2.** Source selon la revendication 1, **caractérisée en ce que** le plasma est excité et confiné par des micro-ondes à la résonance cyclotronique électronique distribuée.

**3.** Source selon la revendication 1, **caractérisée en ce que** le rapport entre la seconde valeur ($S_2$) et la première valeur ($S_1$) est choisi entre D/10 et D.

**4.** Source selon la revendication 1, **caractérisée en ce que** le rapport entre la seconde valeur ($S_2$) et la première valeur ($S_1$) est choisi entre D/2 et D.

**5.** Source selon la revendication 1, **caractérisée en ce que** la grille est divisée en une pluralité de portions de grille élémentaires ($S_{21}$, $S_{22}$, ... $S_{2n}$).

**6.** Source selon la revendication 5, **caractérisée en ce que** diverses portions de grille sont groupées et mises à des potentiels distincts.

**7.** Source selon la revendication 1, **caractérisée en ce qu'**elle est suivie d'une enceinte de post-accélération.

**8.** Source selon la revendication 1 ou 5, **caractérisée en ce que** la grille est formée de tubes parallèles dans lesquels circule un fluide de refroidissement.

**Patentansprüche**

**1.** Quelle zur Abgabe eines Elektronenstrahls mit einstellbarer Energie, umfassend eine aus einer Umschließung (1) mit einer inneren Oberfläche eines ersten Wertes ($S_1$) und einen Extraktionsgitter (2) mit einer Oberfläche eines zweiten Wertes ($S_2$) gebildete Plasmakanunet (P), wobei sich das Potential des Gitters von dem der Umschließung unterscheidet und einstellbar ist, **dadurch gekennzeichnet, daß** das Plasma in multipolaren oder multidipolaren Magnetstrukturen angeregt und eingegrenzt ist, wobei das Verhältnis zwischen dem zweiten Wert ($S_2$) und dem ersten Wert ($S_1$) nahe an der folgenden oberen Grenze liegt:

$$D = \frac{1}{\beta} \sqrt{\frac{2\pi m_e}{m_i}} \exp(-1/2),$$

wobei β der Prozentsatz von Elektronen des Plasmas P, $m_e$ die Elektronenmasse und $m_t$ die Masse der positiv geladenen Ionen ist, woraus folgt, daß die Dichte des Elektronenstroms des extrahierten Strahls im wesentlichen stabil ist, wenn sich die Potentialdifferenz zwischen Gitter und Umschließung ändert.

**2.** Quelle nach Anspruch 1, **dadurch gekennzeichnet, daß** das Plasma mit Hilfe von Mikrowellen bei der verteilten elektronischen Zyklotron-Resonanz angeregt und eingegrenzt ist.

**3.** Quelle nach Anspruch 1, **dadurch gekennzeichnet, daß** das Verhältnis zwischen dem zweiten Wert ($S_2$) und dem ersten Wert ($S_1$) zwischen D/10 und D gewählt ist.

4. Quelle nach Anspruch 1, **dadurch gekennzeichnet, daß** das Verhältnis zwischen dem zweiten Wert ($S_2$) und der ersten Wert ($S_1$) zwischen D/2 und D gewählt ist.

5. Quelle nach Anspruch 1, **dadurch gekennzeichnet, daß** das Gitter in eine Mehrzahl von elementaren Gitterabschnitten ($S_{21}$, $S_{22}$, $S_{2n}$) unterteilt ist.

6. Quelle nach Anspruch 5, **dadurch gekennzeichnet, daß** verschiedene Abschnitte des Gitters gruppiert und auf unterschiedliche Potentiale gebracht sind.

7. Quelle nach Anspruch 1, **dadurch gekennzeichnet, daß** ihr eine Nachbeschleunigungsumschließung nachgeordnet ist.

8. Quelle nach Anspruch 1 oder 5, **dadurch gekennzeichnet, daß** das Gitter durch parallele Stäbe gebildet wird, in welchen ein Kühlfluid zirkuliert.

**Claims**

1. A source providing an electron beam of settable power, comprising a plasma chamber (P) formed of an enclosure (1) having an internal surface area of a first value ($S_1$) and of an extraction grid (2) having a surface area of a second value ($S_2$), the grid potential being different from that of the enclosure and being settable, **characterized in that** the plasma is excited and confined in multipolar or multidipolar magnetic structures, the ratio of the second value ($S_2$) to the first value ($S_1$) being close to the following upper limit:

$$D = \frac{1}{\beta}\sqrt{\frac{2\pi m_e}{m_i}}\exp(-1/2),$$

where:

$\beta$ is the electron ratio of plasma P,
$m_e$ is the mass of the electron, and
$m_i$ is the mass of the positively-charged ions,

whereby the electron current density of the extracted beam is substantially steady when the grid-enclosure potential difference varies.

2. The source of claim 1, **characterized in that** the plasma is excited and confined by microwaves at the distributed electron cyclotron resonance.

3. The source of claim 1, **characterized in that** the ratio between the second value ($S_2$) and the first value ($S_1$) is selected to be between D/10 and D.

4. The source of claim 1, **characterized in that** the ratio between the second value ($S_2$) and the first value ($S_1$) is selected to be between D/2 and D.

5. The source of claim 1, **characterized in that** the grid is divided into a plurality of elementary grid portions ($S_{21}$, $S_{22}$, ... $S_{2n}$).

6. The source of claim 5, **characterized in that** various grid portions are gathered and set to distinct potentials.

7. The source of claim 1, **characterized in that** it is followed by a post-acceleration enclosure.

8. The source of claim 1 or 5, **characterized in that** the gate is formed of parallel tubes run through by a cooling fluid.

Fig 1

Fig 2

Fig 3